# FASCICULE DE BREVET EUROPEEN

(11) **EP 3 459 101 B1**
(45) Date de publication et mention de la délivrance du brevet: **01.12.2021**
(21) Numéro de dépôt: 17730846.7
(22) Date de dépôt: 16.05.2017
(51) Int. Cl.: H01H 59/00

(54) **COMMUTATEUR VARIABLE MICROÉLECTROMÉCANIQUE RADIOFRÉQUENCE**
MIKROELEKTROMECHANISCHER SCHALTER MIT VARIABLER FUNKFREQUENZ
VARIABLE RADIO FREQUENCY MICRO-ELECTROMECHANICAL SWITCH

(30) Priorité: 20.05.2016 FR 1654558
(43) Date de publication de la demande: 27.03.2019
(73) Titulaire: Université de Limoges, 87000 Limoges (FR); Centre National de la Recherche Scientifique, 75016 Paris (FR); Airmems, 87280 Limoges (FR)
(72) Inventeur: STEFANINI, Romain, 87000 Limoges (FR); ZHANG, Ling Yan, 87310 Cognac-La-Forêt (FR); BLONDY, Pierre, 87000 Limoges (FR); ROUBEAU, Fabien, 91540 Mennecy (FR); NADAUD, Kévin, 37130 Cinq-Mars-La-Pile (FR)
(74) Mandataire: Cabinet Chaillot
(86) Numéro de dépôt international: PCT/FR2017/051178
(87) Numéro de publication internationale: WO 2017/198943

(56) Documents cités:
- EP-A2- 1 343 190
- WO-A1-2014/165624
- CN-A- 102 543 591
- US-A1- 2006 056 132

## Description

La présente invention se rapporte de manière générale à un commutateur microélectromécanique radiofréquence (généralement désigné par les acronymes MEMS RF) ainsi qu'à un procédé permettant de réaliser un tel commutateur.

Par commutateur on entend, au sens de la présente invention, un composant électrique ou électronique qui sous l'effet d'une commande externe est capable de changer le niveau de puissance électrique qu'il véhicule sur au moins 2 état distincts.

La demande pour des composants radiofréquences (RF) reconfigurables ne cesse de croitre suite à l'augmentation des besoins en transfert de données sans fil. En effet, la multiplication des normes de télécommunication complexifie les architectures des dispositifs et nécessite l'intégration de composants reconfigurables. Les commutateurs MEMS RF font partie des candidats sérieux permettant de répondre à ce besoin, notamment grâce à leurs pertes électriques faibles, leur comportement hautement linéaire ainsi que leur basse consommation par rapport aux semi-conducteurs classiques.

Ces commutateurs MEMS RF peuvent être combinés sous la forme de matrices digitales, cette combinaison permettant d'obtenir un dispositif possédant une variation unitaire bien définie et précise, une haute linéarité de la réponse électrique, ainsi que de faibles pertes électriques. D'autres technologies, telles que l'empilement de transistors MOS à capacité fixe peuvent être utilisées dans la même optique. Ces transistors MOS peuvent être réalisés à faible couts et sont faciles à intégrer, ils ont cependant un facteur de qualité Q modéré, c'est-à-dire que l'inverse du produit de la résistance série par la valeur de capacité minimale qu'elle peut atteindre est modéré. Plus ce facteur Q est élevé, plus le commutateur est considéré performant.

Ainsi, si l'on veut profiter des facteurs de qualité plus élevés des commutateurs MEMS tout en réduisant les coûts de fabrication, la taille du commutateur et la simplicité de réalisation sont des aspects critiques qui doivent être améliorés pour supplanter les technologies semi-conductrices.

Jusqu'à présent, de nombreux efforts de simplification du procédé de fabrication des commutateurs MEMS RF ont été menés. Leur intégration dans une chaine de production standard en couches minces (CMOS par exemple) permettrait une réduction drastique des coûts de réalisation. Ainsi, la demande de brevet US20150235771 décrit une capacité MEMS réalisée par couches minces présentant une ligne RF, ainsi que des électrodes de contrôle insérées dans le substrat, une membrane MEMS pouvant se déplacer lors de l'application d'une tension sur les électrodes de contrôle ou la ligne RF, la membrane MEMS étant insérée dans une cavité hermétique, avec une électrode de contrôle placée au-dessus de la cavité et une couche de diélectrique enserrant l'ensemble. Cependant, cette configuration présente l'inconvénient d'induire une grande résistivité de la ligne RF et des pertes par capacité parasites. De plus, la réalisation de ce MEMS utilise encore beaucoup d'étapes de procédé, ce qui rend sa fabrication complexe et chère.

Le document CN 102543591 divulgue un commutateur microélectromécanique radiofréquence, possédant un dôme avec une ouverture centrale, en regard avec la membrane, rebouchée par une ligne que l'homme du métier peut considérer RF, et une ou plusieurs ouvertures latérales permettant la libération des couches sacrificielles et refermées par une couche diélectrique afin d'encapsuler hermétiquement la membrane MEMS.

Afin de répondre au problème posé en évitant les inconvénients précités, le demandeur a mis au point un commutateur microélectromécanique radiofréquence, selon la revendication 1.

Dans le commutateur selon l'invention, le positionnement de la deuxième ligne RF permet d'utiliser des lignes RF possédant une plus grande épaisseur (par exemple de l'ordre de 5 microns) par rapport aux lignes RF de l'état de l'art. Cette épaisseur plus grande permet d'obtenir des résistances série très faibles, ce qui augmente les performances RF du composant. De plus, cette configuration permet de créer un commutateur possédant de faibles capacités parasites grâce à la présence d'un gap d'air sous les lignes RF.

La configuration du commutateur selon l'invention est essentiellement compacte et cette compacité permet de réduire la sensibilité à la température du commutateur, de limiter les coûts de fabrication et de faciliter l'intégration de matrices de commutateurs dans des circuits RF par exemple.

Le dôme du commutateur selon l'invention peut en outre être recouvert d'une couche de métal discontinue, recouvrant sa face externe.

Par couche discontinue on entend, au sens de la présente invention, une couche comprenant des motifs disjoints (points, lignes, formes géométrique...), pouvant ou non être reliés entre eux. En outre, certains motifs peuvent être reliés à la première ligne RF ou à la deuxième ligne RF. Avantageusement, la membrane MEMS, qui peut être de forme quelconque, peut en outre comprendre une couche de diélectrique et/ou une ou plusieurs couches de métal supplémentaires. Ce diélectrique peut, par exemple, être choisi dans la liste composée de l'alumine, de l'oxyde de silicium et du nitrure de silicium.

Avantageusement, la deuxième section de la deuxième ligne RF peut être au moins partiellement insérée dans ladite couche diélectrique formant le dôme. Cette configuration permet notamment d'obtenir une valeur de capacité plus forte lorsque la membrane est défléchie vers le haut de manière qu'elle rentre en contact avec la surface inférieure du dôme

Avantageusement, le commutateur selon l'invention comprenant en outre :
- une ou plusieurs électrodes d'activation supérieures reliées entre elles électriquement et aptes à défléchir ladite membrane MEMS par une activation électrostatique, ladite électrode d'activation supérieure étant disposée sur la face externe du dôme et/ou une ou plusieurs électrodes d'activation centrales reliées entre elles électriquement et aptes à défléchir ladite membrane MEMS par une activation électrostatique, ladite électrode d'activation centrale étant disposée sur la face interne du dôme et/ou une ou plusieurs électrodes d'activation inférieures reliées entre elles électriquement et aptes à défléchir ladite membrane MEMS par une activation électrostatique, ladite électrode d'activation inférieure étant disposée sur ladite face du substrat dans la cavité hermétique.

L'activation de type électrostatique de la membrane MEMS peut donc être réalisée par deux moyens différents :
- l'activation est effectuée par une ligne RF :
   dans ce cas, une tension continue est appliquée entre la deuxième ligne de signal RF et la membrane.
   Cette tension crée une force électrostatique qui va défléchir la membrane MEMS vers la deuxième section de la deuxième ligne RF. Lorsque la tension est abaissée et qu'elle n'est plus suffisante pour compenser la force de rappel, la membrane reprend sa position initiale sensiblement parallèle à la face du substrat, ou

- l'activation est effectuée par les électrodes d'activation :
   lorsqu'une tension électrique continue est appliquée entre les électrodes et la membrane MEMS, une force électrostatique se crée et va défléchir la membrane MEMS vers l'électrode. Lorsque la tension est abaissée et qu'elle n'est plus suffisante pour compenser la force de rappel, la membrane reprend sa position initiale sensiblement parallèle à la face du substrat. Cette activation permet de contrôler la membrane mobile indépendamment des signaux RF.

Avantageusement, le commutateur selon l'invention peut comprendre une ou plusieurs électrodes d'activation supérieures chacune d'entre elles étant reliées électriquement à une électrode centrale au moyen d'un via métallique.

Avantageusement, le commutateur selon l'invention peut comprendre un ou plusieurs plots d'arrêt disposés dans la cavité de manière à empêcher tout contact entre les électrodes d'activation centrales ou inférieures et la membrane MEMS lorsqu'elle est défléchie. Dans ce mode de réalisation avantageux, ce plot peut se trouver :
- sous la face inferieure du dôme : le plot pourra alors limiter la déflexion de la membrane et ainsi empêcher tout contact entre la membrane MEMS et les électrodes d'activation centrales,
- sur la face du substrat : le plot pourra alors limiter la déflexion de la membrane MEMS et ainsi empêcher tout contact entre la membrane MEMS et les électrodes d'activation inférieures,

- sur la membrane MEMS : le plot pourra alors limiter la déflexion de la membrane MEMS et ainsi empêcher tout contact entre la membrane MEMS et les électrodes d'activation centrales,
- sous la membrane MEMS : le plot pourra alors limiter la déflexion de la membrane MEMS et ainsi empêcher tout contact entre la membrane MEMS et les électrodes d'activation inférieures.

Le commutateur selon l'invention peut être utilisé soit comme une capacité commutée, soit comme un commutateur ohmique.

Dans le cas où le commutateur selon l'invention est utilisé comme un commutateur ohmique, le dôme comporte au moins ouverture dans laquelle est logée un plot métallique qui est formé en prolongement de ladite deuxième section de la deuxième ligne RF, de manière que ladite membrane MEMS et ladite deuxième section de la deuxième ligne RF soient aptes à rentrer en contact lorsque ladite membrane MEMS est activée par une électrode d'activation supérieure ou centrale de manière à former ainsi un contact ohmique.

Dans le cas où le commutateur selon l'invention est utilisé comme capacité, le dôme comprend au moins une couche de diélectrique séparant la membrane MEMS et la deuxième section de la deuxième ligne RF, de manière à former une capacité Métal-Diélectrique-Métal. Dans ce mode de réalisation, une couche de métal peut être avantageusement disposée sous ladite couche de diélectrique et vient en contact avec la membrane MEMS lorsque ladite membrane est défléchie en direction du dôme.

Le commutateur selon l'invention peut donc être utilisé soit comme capacité, soit comme contact ohmique, ces modes de réalisation bénéficiant chacun de l'augmentation des propriétés RF apportée par le positionnement de ladite deuxième ligne RF sur la partie supérieure du dôme. Dans le cas de la capacité, la distance variable entre ladite membrane MEMS et la deuxième section de la deuxième ligne RF permet de faire varier la valeur de capacité électrique et modifie l'isolation en puissance du dispositif. De la même façon, lorsque le commutateur est de type ohmique, il isole du courant RF lorsque la membrane n'est pas activée et laisse passer le courant lorsqu'il est activé, à la manière d'un interrupteur.

De plus, Le dôme peut être fermé hermétiquement par le métal constituant l'une des lignes RF ou les deux lignes RF et la cavité peut contenir un gaz (par exemple air, N₂, Ar, ou O₂) ou du vide (vide primaire ou secondaire).

La présente invention concerne aussi un microsystème électromécanique radiofréquences (MEMS RF) comprenant un commutateur selon l'invention.

Enfin, la présente invention a aussi pour objet un procédé de fabrication d'un commutateur selon l'invention, tel que défini par la revendication 11.

La deuxième ligne RF ainsi formée comprend une première section en contact avec la face essentiellement plane du substrat et une deuxième section adjacente à ladite première section.

Les ouvertures formées lors de l'étape d) sont des ouvertures latérales, c'est-à-dire des ouvertures, qui ne sont pas en regards de la face supérieure de la membrane MEMS.

L'élimination des couches sacrificielles peut être réalisée par gravure sèche ou gravure humide. Dans le cas d'une gravure humide, la membrane MEMS est contenue dans un liquide, qui doit ensuite passer de l'état liquide à l'état gazeux : cette transformation peut être réalisée par un séchage à point critique (usuellement désigné par l'acronyme CPD pour l'expression en anglais « *critical point dryer* » en anglais).

D'autres avantages et particularités de la présente invention résulteront de la description qui va suivre, donnée à titre d'exemple non limitatif et faite en référence aux figures annexées :
- la figure 1 montre un schéma d'un commutateur selon l'invention en vue de dessus (figure la), en vue en coupe suivant la ligne AA' (figure 1b) et en vue en coupe suivant la ligne BB' (figure 1c) ;
- la figure 2 montre une vue schématique en coupe suivant la ligne AA' d'un commutateur selon l'invention dans le cas où il est utilisé comme capacité et où la deuxième ligne RF est insérée partiellement dans la couche diélectrique du dôme ;
- la figure 3 montre une vue schématique en coupe suivant la ligne AA' d'un commutateur selon l'invention dans le cas où il est utilisé comme capacité et présentant deux électrodes d'activation disposées sur le dôme et une couche métallique disposée sous la couche diélectrique du dôme ;
- la figure 4 montre un schéma d'un commutateur selon l'invention dans le cas où il est utilisé comme contacteur ohmique et possède des électrodes supérieures et centrales reliées entre elles, avec une vue en coupe suivant la ligne AA' (figure 4a) et une vue en coupe suivant la ligne BB' (figure 4b) ;
- la figure 5 montre une vue schématique en coupe suivant la ligne AA' d'un commutateur selon l'invention dans le cas où il est utilisé comme contact capacitif et possède des électrodes supérieures et un plot d'arrêt ;
- la figure 6 montre une vue schématique en coupe suivant la ligne AA' d'un commutateur selon l'invention dans le cas où il est utilisé comme commutateur ohmique et possède des électrodes centrales et inférieures et un plot d'arrêt ;
- la figure 7 montre des vues schématiques des différentes étapes successives a) à g) de réalisation d'un commutateur selon l'invention, avec une vue en coupe selon la ligne AA' (figure 7a) et une vue en coupe selon la ligne BB' (figure 7b) .

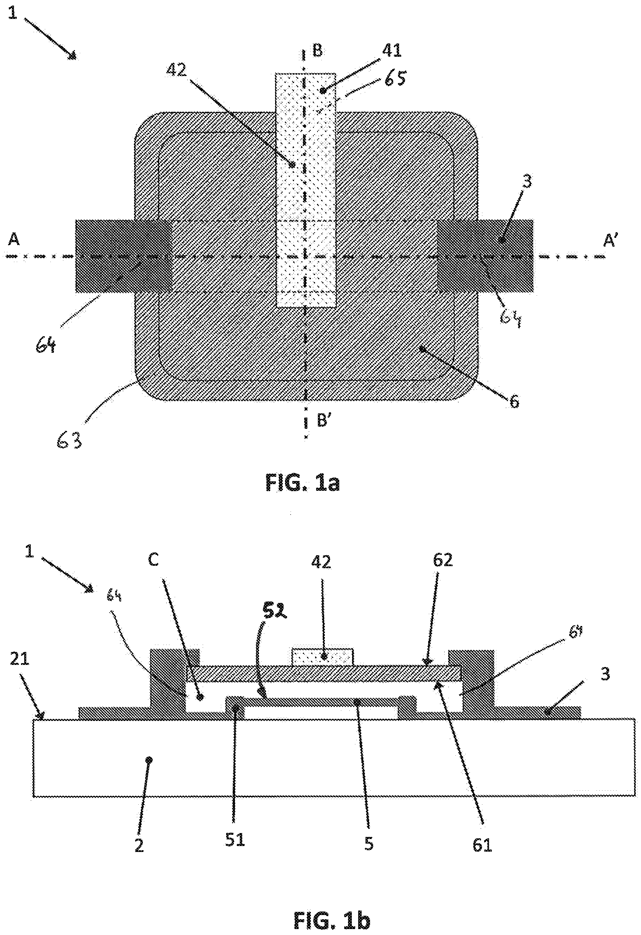

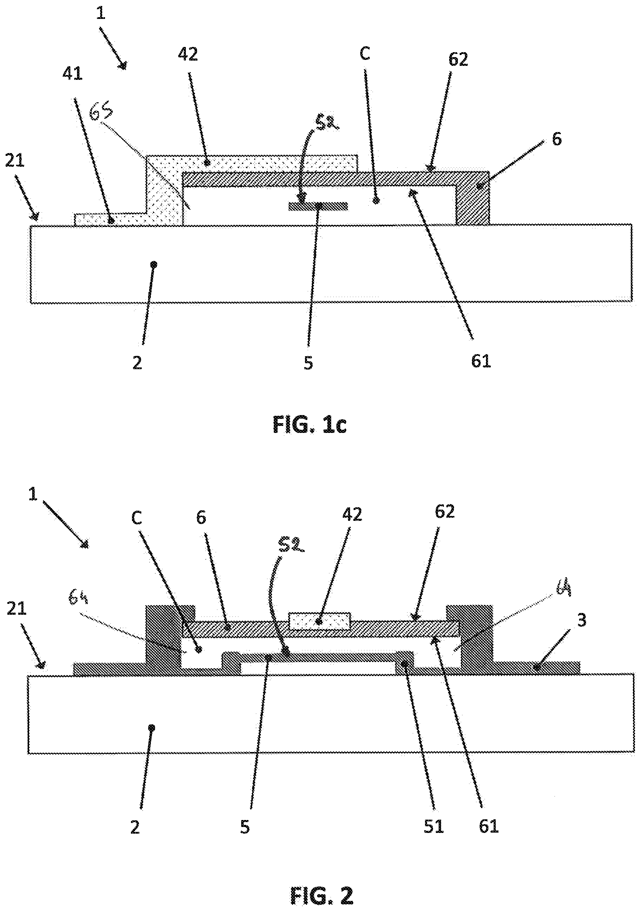

La figure 1 montre un schéma d'un commutateur selon l'invention en vue de dessus. La première ligne RF 3 est connectée électriquement à la membrane MEMS 5 par des ancrages 51, permettant ainsi à un signal RF traversant la membrane MEMS 5 de se propager dans la première ligne RF 3. La deuxième ligne RF 4 possède une première section 41 en contact avec la face 21 du substrat 2 et une deuxième section 42 recouvrant partiellement le dôme 6. Ces deux sections sont reliées électriquement entre elles permettant ainsi à un signal RF traversant la première section 41 de se propager dans la deuxième section 42 (figure 1a).

L'empilement comprenant la membrane MEMS 5, le diélectrique (comprenant la couche diélectrique du dôme ainsi que la couche d'air éventuelle entre la membrane 5 et la couche de diélectrique du dôme si la membrane 5 n'est pas complètement défléchie), et la deuxième section 42 de la deuxième ligne RF 4 forme la capacité. Le signal se propage d'une ligne RF à une autre à travers cet empilement. Lorsque la membrane 5 est défléchie vers la ligne RF 4 et qu'elle vient en contact avec le dôme diélectrique, la capacité est plus élevée. Le commutateur selon l'invention peut donc être utilisé comme capacité commutée. Dans ce cas particulier, l'activation de la membrane est réalisée par la ligne RF.

Le dôme 6 de la figure 1 comprend au moins une couche diélectrique et est recouvert d'une couche métallique qui peut être discontinue dont les motifs la composant sont reliés à la première ligne RF 3 (figure 1b). Le métal constitutif des lignes RF 3 et RF 4 permettent de garantir l'herméticité de la cavité.

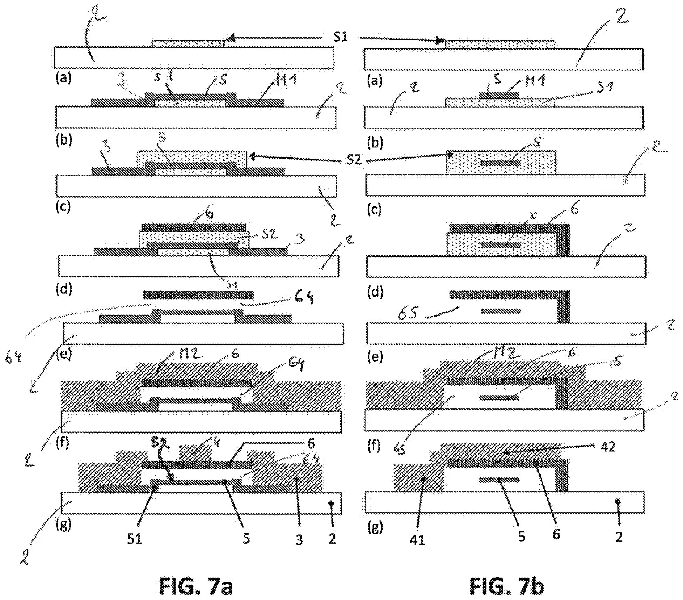

Le dôme 6 présente plusieurs points d'ancrage 63 sur la face plane 21 du substrat 2 et trois ouvertures 64, 65 pouvant permettre l'élimination de couches sacrificielles S1, S2 ayant servi à l'élaboration de la membrane MEMS 5 et du dôme 6 (cf. description des figures 7a et 7b ci-après) : deux ouvertures 64 refermées par la première ligne RF 3 (visibles sur les figures la et 1b) et une ouverture 65 refermée par la deuxième ligne RF 4 (visible sur les figures la et 1c). Comme le montrent la figure 1b (pour l'ouverture 64) et la figure 1c (pour l'ouverture 65), ces ouvertures sont des ouvertures latérales, qui ne sont pas en regard de la face supérieure 51 de la membrane MEMS 5.

La figure 2 montre une vue schématique en coupe d'un commutateur selon l'invention dans le cas où il est utilisé comme capacité et où la deuxième ligne RF 4 est insérée partiellement dans la couche diélectrique du dôme 6. Dans ce cas particulier, la deuxième section 42 de la deuxième ligne RF 4 est toujours séparée de la membrane MEMS par au moins une couche de diélectrique 8. Plus la ligne RF est insérée en profondeur dans le dôme 6, plus la capacité maximale, obtenue lorsque la membrane MEMS 5 vient rentrer en contact avec le dôme 6, est forte.

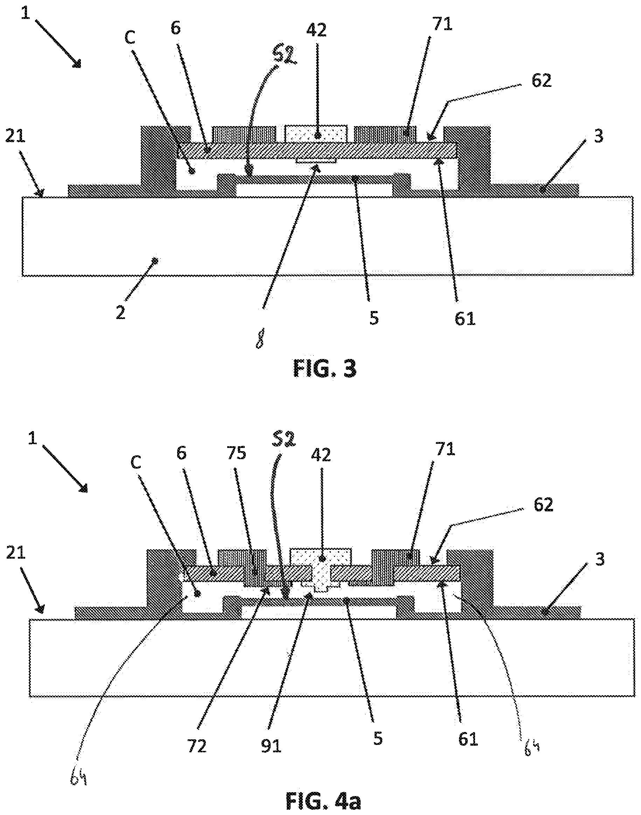

La figure 3 montre une vue schématique en coupe d'un commutateur selon l'invention dans le cas où il est utilisé comme capacité et où une couche métallique 8 est disposée sous la couche de diélectrique. L'avantage de ce procédé est de permettre une reproductibilité quasi-parfaite de la capacité commutée moyennant une légère dégradation du facteur de qualité.

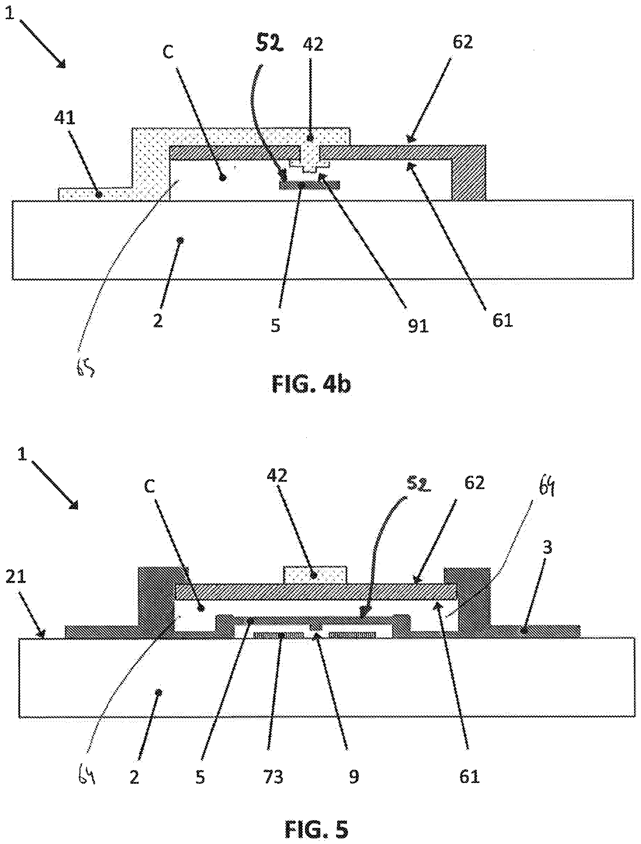

La figure 4 montre une vue schématique en coupe d'un commutateur selon l'invention dans le cas où il est utilisé comme contact ohmique et possède des électrodes supérieures 71 et centrales 72. Dans ce cas particulier, chacune des électrodes d'activation supérieures 71 est reliée à une électrode centrale 72 par un via métallique 75 traversant le dôme 6 (figure 4a). Les électrodes d'activation sont essentielles dans le cas du contact ohmique, l'activation de la membrane ne pouvant être réalisée via les lignes RF qui viennent en contact.

Le contact ohmique de la figure 4 se fait via un plot de contact métallique 91 traversant le dôme et étant en contact avec la deuxième ligne RF 4. Lorsque la membrane est défléchie, elle rentre en contact avec ledit plot métallique et permet le passage des courants RF entre les deux lignes RF (lignes RF 3 et RF 4).

La figure 5 montre une vue schématique en coupe d'un commutateur selon l'invention dans le cas où il est utilisé comme capacité variable et où il possède des électrodes inférieures 73 et un plot d'arrêt 9. Ce plot peut ici, soit être placé sous la membrane MEMS 5 et en contact avec ladite membrane ou sur la face 21 du substrat 2 et en contact avec ladite face. Lors de la déflexion de la membrane vers les électrodes inférieures 73, le plot limite la déflexion de la membrane MEMS 5 vers les électrodes inférieures 73, laissant un gap d'air entre la membrane MEMS 5 et les électrodes inférieures 73. Sans ce plot, les électrodes inférieures 73 pourraient rentrer en contact avec la membrane, ce qui chargerait la membrane 5 et provoquer une défaillance du dispositif.

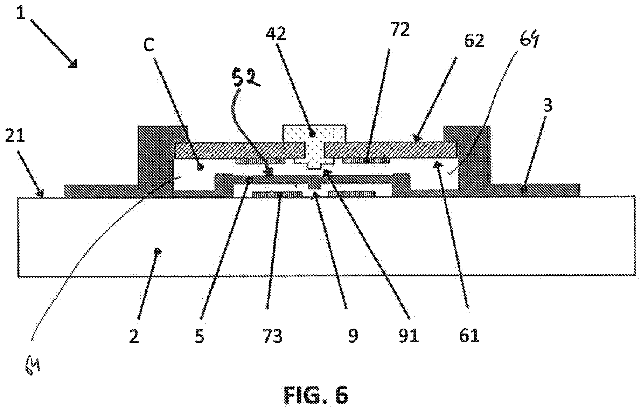

La figure 6 montre une vue schématique en coupe suivant la ligne AA' d'un commutateur selon l'invention dans le cas où il est utilisé comme contact ohmique et possède des électrodes centrales 72 et inférieures 73. Les électrodes d'activation 71, 73 ne peuvent défléchir la membrane 5 dans leur direction. Ainsi, le fait d'ajouter des électrodes inférieures 73 permet de défléchir la membrane 5 vers le substrat 2 et d'augmenter l'amplitude des variations de propriétés électriques du dispositif.

La figure 7 montre des vues schématiques des différentes étapes successives a) à g) de réalisation d'un commutateur selon l'invention, avec une vue en coupe selon la ligne AA' (figure 7a) et une vue en coupe selon la ligne BB' (figure 7b).

Sur les figures 7a et 7b, les schémas correspondant à l'étape (a) montrent une première couche sacrificielle S1 déposée sur le substrat 2 après sa mise en forme.

Sur les figures 7a et 7b, les schémas correspondant à l'étape (b) montrent une première couche métallique M1 déposée sur la première couche sacrificielle S1. Cette première couche métallique M1 est mise en forme par gravure (sèche ou humide) pour créer la première ligne RF 3 et la membrane MEMS 5, ces deux composants étant reliés électriquement entre eux par les ancrages 51 de la membrane MEMS.

Sur les figures 7a et 7b, les schémas correspondant à l'étape (c) montrent la deuxième couche sacrificielle S2 après sa mise en forme.

Sur les figures 7a et 7b, les schémas correspondant à l'étape (d) montrent la couche diélectrique après sa mise en forme pour créer le dôme 6. Le dôme 6 est ancré dans le substrat 2 et laisse passer la première ligne RF 3 afin de permettre la connexion avec la membrane MEMS 5.

Les ouvertures 64, 65 permettent la gravure sèche ou la gravure humide des couches sacrificielles, la gravure humide nécessitant une étape supplémentaire de séchage par point critique.

Sur les figures 7a et 7b, les schémas correspondant à l'étape (e) montrent le résultat de l'étape d'élimination des couches sacrificielles.

Sur les figures 7a et 7b, les schémas correspondant à l'étape (f) montrent que l'étape f) est une étape de dépôt d'une deuxième couche métallique M2, cette couche étant destinée à servir de base pour former les différents motifs de l'étape suivante.

Comme illustré sur les schémas correspondant à l'étape (g) des figures 7a et 7b, cette deuxième couche métallique M2 est mise en forme par enlèvement et/ou gravure (sèche ou humide) pour créer la deuxième ligne RF 4 et pour refermer les ouvertures 64, 65 formées lors de l'étape précédente, de manière. Cette deuxième ligne RF4 se décompose en une première section 41 en contact avec la face plane 21 du substrat 2, et une deuxième section 42 adjacente à la première section 41 (c'est-à-dire qui lui est électriquement connectée). L'une au moins de ladite deuxième ligne RF 4 et de ladite première ligne RF 3 referme les ouvertures latérales 64, 65, créant ainsi une cavité hermétique C qui encapsule la membrane MEMS.

## Revendications

1. Commutateur microélectromécanique radiofréquence (1), comprenant :
- un substrat (2) semi-conducteur et/ou isolant présentant une face essentiellement plane (21) ;
- une première ligne RF (3) apte à véhiculer un signal RF, ladite première ligne RF (3) comprenant au moins une couche métallique, ladite première ligne RF (3) étant disposée sur ladite face (21) du substrat (2) ;
- une deuxième ligne RF (4) apte à véhiculer un signal RF, ladite deuxième ligne RF (4) comprenant au moins une couche métallique ;
- une membrane MEMS (5) apte à être défléchie par une ou plusieurs activations de type électrostatique vers le substrat (2) ou dans le sens opposé, ladite membrane MEMS (5) comprenant au moins une couche de métal et étant sensiblement parallèle au substrat (2) et étant connectée à la première ligne RF (3) par l'intermédiaire d'un ou plusieurs ancrages (51) ;
- un dôme (6), comprenant une face interne (61) en regard de ladite face essentiellement plane (21) du substrat (2) et une face externe (62) opposée à ladite face interne (61), ledit dôme (6) comprenant au moins une couche diélectrique, ledit dôme (6) étant disposé entre la deuxième ligne RF (4) et la membrane MEMS (5), et présentant un ou plusieurs ancrages sur ladite face essentiellement plane (21) du substrat (2) et au moins une ouverture latérale,
ledit commutateur étant **caractérisé en ce que** ladite deuxième ligne RF (4) comprend au moins une première section (41) en contact avec ladite face essentiellement plane (21) du substrat (2), et une deuxième section (42) adjacente et électriquement connectée à ladite première section (41), ladite deuxième section (42) recouvrant au moins partiellement la partie supérieure dudit dôme (6), et l'une au moins de ladite deuxième ligne RF (4) et de ladite première ligne RF (3) refermant ladite ouverture latérale de manière à créer une cavité hermétique (C) encapsulant ladite membrane MEMS (5).

2. Commutateur (1) selon la revendication 1 dans lequel la membrane MEMS (5) comprend en outre au moins une couche de diélectrique et/ou une ou plusieurs couches de métal supplémentaires.

3. Commutateur (1) selon les revendications 1 ou 2, dans lequel ladite deuxième section (42) de la deuxième ligne RF (4) est au moins partiellement insérée dans ladite couche diélectrique du dôme (6).

4. Commutateur (1) selon l'une quelconque des revendications 1 à 3, comprenant en outre :
- une ou plusieurs électrodes d'activation supérieures (71) reliées entre elles électriquement et aptes à défléchir ladite membrane MEMS (5) par une activation électrostatique, ladite électrode d'activation supérieure (71) étant disposée sur la face externe (61) du dôme (6) et/ou
- une ou plusieurs électrodes d'activation centrales (72) reliées entre elles électriquement et aptes à défléchir ladite membrane MEMS (5) par une activation électrostatique, ladite électrode d'activation centrale (72) étant disposée sur la face interne (62) du dôme (6) et/ou
- une ou plusieurs électrodes d'activation inférieures (72) reliées entre elles électriquement et aptes à défléchir ladite membrane MEMS (5) par une activation électrostatique, ladite électrode d'activation inférieure (73) étant disposée sur ladite face (21) du substrat (2) dans la cavité hermétique (C).

5. Commutateur (1) selon la revendication 4, comprenant une ou plusieurs électrodes d'activation supérieure (71) chacune d'entre elles étant reliées électriquement à une électrode centrale au moyen d'un via métallique (75).

6. Commutateur (1) selon les revendications 4 ou 5, comprenant un ou plusieurs plots d'arrêt (9) disposés dans la cavité (C) de manière à empêcher tout contact entre les électrodes d'activation centrales ou inférieures (72, 73) et la membrane MEMS (5) lorsqu'elle est défléchie.

7. Commutateur (1) selon l'une quelconque des revendications 4 à 6, dans lequel ledit dôme (6) comporte au moins une ouverture dans laquelle est logée un plot métallique (91) qui est formé en prolongement de ladite deuxième section (42) de la deuxième ligne RF (4), de manière que ladite membrane MEMS (5) et ladite deuxième section (42) de la deuxième ligne RF (4) soient aptes à rentrer en contact lorsque ladite membrane MEMS (5) est activée par une électrode d'activation supérieure (71) ou centrale (72) de manière à former ainsi un contact ohmique.

8. Commutateur (1) selon l'une quelconque des revendications 1 à 6, dans lequel le dôme comprend au moins une couche de diélectrique séparant la membrane MEMS (5) et la deuxième section (42) de la deuxième ligne RF (4), de manière à former une capacité Métal-Diélectrique-Métal lorsque la membrane est activée et en contact avec le dôme.

9. Commutateur (1) selon la revendication 8, dans lequel une couche de métal (63) est disposée sous ladite couche de diélectrique (62) et vient en contact avec la membrane MEMS (5) lorsque ladite membrane est défléchie en direction du dôme.

10. Microsystème électromécanique radiofréquences (MEMS RF) comprenant un commutateur (1) tel que défini selon l'une quelconque des revendications 1 à 9.

11. Procédé de fabrication d'un commutateur (1) tel que défini selon l'une quelconque des revendications 1 à 9, comprenant les étapes suivantes :
a) dépôt, sur une face (21) essentiellement plane d'un substrat (2) semi-conducteur ou isolant, d'une première couche sacrificielle (S1), et réalisation d'un motif par enlèvement et/ou gravure d'une partie de cette couche (S1) ;
b) dépôt, sur ladite première couche sacrificielle (S1) et sur ladite face du substrat (21), d'au moins une première couche de métal; puis réalisation d'un motif par enlèvement et/ou gravure d'une partie de ladite couche de métal, pour former la première ligne RF (3) et la membrane MEMS (5) en connectant cette dernière (5) à ladite première ligne RF (3) par l'intermédiaire d'un ou plusieurs ancrages (51) ;
c) dépôt sur ladite première ligne RF (3) d'une deuxième couche sacrificielle (S2) ; puis réalisation d'un motif par enlèvement et/ou gravure d'une partie de cette couche (S2) ;
d) dépôt sur ladite deuxième couche sacrificielle (S2) d'une couche de diélectrique ; puis réalisation d'un motif par enlèvement et/ou gravure d'une partie de la couche diélectrique, pour former le dôme (6) présentant une face interne (61) en regard de ladite face (21) du substrat (2), une face externe (62) opposée à ladite face interne (61) ainsi que des ouvertures latérales (64, 65) dans ledit dôme (6);
e) élimination des couches sacrificielles (S1, S2) au travers desdites ouvertures latérales (64, 65) ; puis
f) dépôt, sur ladite face externe (62) dudit dôme (6) et sur ladite face (21) essentiellement plane du substrat (2), d'au moins une deuxième couche métallique ; puis réalisation d'un motif permettant de reboucher lesdites ouvertures latérales (64, 65) et formant la deuxième ligne RF (4) par enlèvement et/ou gravure d'une partie de ladite deuxième couche métallique, ladite deuxième ligne RF (4) comprenant une première section (41) en contact avec ladite face (21) essentiellement plane du substrat (2) et une deuxième section (42) adjacente à ladite première section (41).

## Patentansprüche

1. Mikroelektromechanischer Funkfrequenzschalter (1), umfassend:
- ein Halbleiter- und/oder Isoliersubstrat (2) mit einer im Wesentlichen ebenen Fläche (21) ;
- eine erste HF-Leitung (3), die zum Führen eines HF-Signals geeignet ist, wobei die erste HF-Leitung (3) mindestens eine Metallschicht umfasst, wobei die erste HF-Leitung (3) auf der Fläche (21) des Substrats (2) angeordnet ist; und
- eine zweite HF-Leitung (4), die zur Führen eines HF-Signals geeignet ist, wobei die zweite HF-Leitung (4) mindestens eine Metallschicht umfasst;
- eine MEMS-Membran (5), die durch eine oder mehrere Aktivierungen von elektrostatischen Typ in Richtung des Substrats (2) oder in die entgegengesetzte Richtung ausgelenkt werden kann, wobei die MEMS-Membran (5) mindestens eine Metallschicht umfasst und im Wesentlichen parallel zu dem Substrat (2) ist und über eine oder mehrere Verankerungen (51) mit der ersten HF-Leitung (3) verbunden ist;
- eine Kuppel (6), die eine Innenfläche (61), die der im Wesentlichen flachen Fläche (21) des Substrats (2) zugewandt ist, und eine Außenfläche (62) gegenüber der Innenfläche (61) aufweist, wobei die Kuppel (6) mindestens eine dielektrische Schicht aufweist, wobei die Kuppel (6) zwischen der zweiten HF-Leitung (4) und der MEMS-Membran (5) angeordnet ist und eine oder mehrere Verankerungen auf der im Wesentlichen flachen Fläche (21) des Substrats (2) und mindestens eine seitliche Öffnung aufweist
wobei der Schalter **dadurch gekennzeichnet ist, dass** die zweite HF-Leitung (4) mindestens einen ersten Abschnitt (41) in Kontakt mit der im Wesentlichen ebenen Fläche (21) des Substrats (2) und einen zweiten Abschnitt (42) umfasst, der an den ersten Abschnitt (41) angrenzt und elektrisch mit diesem verbunden ist, wobei der zweite Abschnitt (42) zumindest teilweise die Oberseite der Kuppel (6) bedeckt, und wobei zumindest eine von der zweiten HF-Leitung (4) und der ersten HF-Leitung (3) die seitliche Öffnung verschließt, um einen hermetischen Hohlraum (C) zu erzeugen, der die MEMS-Membran (5) einkapselt.

2. Schalter (1) nach Anspruch 1, wobei die MEMS-Membran (5) weiterhin mindestens eine dielektrische Schicht und/oder eine oder mehrere zusätzliche Metallschichten umfasst.

3. Schalter (1) nach Anspruch 1 oder 2, wobei der zweite Abschnitt (42) der zweiten HF-Leitung (4) zumindest teilweise in die dielektrische Schicht der Kuppel (6) eingesetzt ist.

4. Schalter (1) nach einem der Ansprüche 1 bis 3, ferner umfassend:
- eine oder mehrere obere Aktivierungselektroden (71), die elektrisch miteinander verbunden und in der Lage sind, die MEMS-Membran (5) durch elektrostatische Aktivierung auszulenken, wobei die obere Aktivierungselektrode (71) auf der Außenfläche (61) der Kuppel (6) angeordnet ist und/oder
- eine oder mehrere mittlere Aktivierungselektroden (72), die elektrisch miteinander verbunden und in der Lage sind, die MEMS-Membran (5) durch elektrostatische Aktivierung auszulenken, wobei die mittlere Aktivierungselektrode (72) auf der Innenfläche (62) der Kuppel (6) angeordnet ist und/oder
- eine oder mehrere untere Aktivierungselektroden (72), die elektrisch miteinander verbunden und in der Lage sind, die MEMS-Membran (5) durch elektrostatische Aktivierung auszulenken, wobei die untere Aktivierungselektrode (73) auf der Fläche (21) des Substrats (2) in dem hermetischen Hohlraum (C) angeordnet ist.

5. Schalter (1) nach Anspruch 4, umfassend eine oder mehrere obere Aktivierungselektroden (71), von denen jede mittels einer metallischen Bohrung (75) elektrisch mit einer mittleren Elektrode verbunden ist.

6. Schalter (1) nach Anspruch 4 oder 5, mit einem oder mehreren Anschlagspads (9), die in dem Hohlraum (C) angeordnet sind, um einen Kontakt zwischen den mittleren oder unteren Aktivierungselektroden (72, 73) und der MEMS-Membran (5) zu verhindern, wenn sie ausgelenkt wird.

7. Schalter (1) nach einem der Ansprüche 4 bis 6, wobei die Kuppel (6) mindestens eine Öffnung aufweist, in der ein Metallpad (91) untergebracht ist, das in Verlängerung des zweiten Abschnitts (42) der zweiten HF-Leitung (4) ausgebildet ist, so dass die MEMS-Membran (5) und der zweite Abschnitt (42) der zweiten HF-Leitung (4) in der Lage sind, sich gegenseitig zu kontaktieren, wenn die MEMS-Membran (5) durch eine obere (71) oder mittlere (72) Aktivierungselektrode aktiviert wird, um dadurch einen ohmschen Kontakt zu bilden.

8. Schalter (1) nach einem der Ansprüche 1 bis 6, wobei die Kuppel mindestens eine dielektrische Schicht umfasst, die die MEMS-Membran (5) und den zweiten Abschnitt (42) der zweiten HF-Leitung (4) trennt, um eine Metall-Dielektrikum-Metall-Kapazität zu bilden, wenn die Membran aktiviert ist und in Kontakt mit der Kuppel steht.

9. Schalter (1) nach Anspruch 8, wobei eine Metallschicht (63) unter der dielektrischen Schicht (62) angeordnet ist und die MEMS-Membran (5) kontaktiert, wenn die Membran in Richtung der Kuppel ausgelenkt wird.

10. Elektromechanischer Funkfrequenzsmikrosystem (HF-MEMS) mit einem Schalter (1) nach einem der Ansprüche 1 bis 9.

11. Verfahren zur Herstellung eines Schalters (1) nach einem der Ansprüche 1 bis 9, umfassend die folgenden Schritte:
a) Abscheidung einer ersten Opferschicht (S1) auf einer im wesentlichen ebenen Fläche (21) eines Halbleiter- oder Isoliersubstrats (2) und Erzeugung eines Musters durch Entfernen und/oder Ätzen eines Teils dieser Schicht (S1) ;
b) Abscheidung auf der ersten Opferschicht (S1) und auf der Fläche des Substrats (21) von mindestens einer ersten Metallschicht; dann Erzeugung eines Musters durch Entfernen und/oder Ätzen eines Teils der Metallschicht, um die erste HF-Leitung (3) und die MEMS-Membran (5) zu bilden, indem die letztere (5) mit der ersten HF-Leitung (3) mittels einer oder mehrerer Verankerungen (51) verbunden wird;
c) Abscheidung einer zweiten Opferschicht (S2) auf der ersten HF-Linie (3); dann Erzeugung eines Musters durch Entfernen und/oder Ätzen eines Teils dieser Schicht (S2);
d) Abscheidung einer dielektrischen Schicht auf der zweiten Opferschicht (S2); dann Erzeugung eines Musters durch Entfernen und/oder Ätzen eines Teils der dielektrischen Schicht, um die Kuppel (6) zu bilden, die eine der Fläche (21) des Substrats (2) zugewandte Innenfläche (61), eine der Innenfläche (61) gegenüberliegende Außenfläche (62) sowie seitliche Öffnungen (64, 65) in der Kuppel (6) aufweist
e) Entfernen der Opferschichten (S1, S2) durch die seitlichen Öffnungen (64, 65); dann
f) Abscheidung mindestens einer zweiten Metallschicht auf der Außenfläche (62) der Kuppel (6) und auf der im Wesentlichen ebenen Fläche (21) des Substrats (2); dann Erzeugung eines Musters, das es ermöglicht, die seitlichen Öffnungen (64, 65) zu verschließen, und die zweite HF-Leitung (4) durch Entfernen und/oder Ätzen eines Teils der zweiten Metallschicht bildet, wobei die zweite HF-Leitung (4) einen ersten Abschnitt (41) in Kontakt mit der im Wesentlichen flachen Fläche (21) des Substrats (2) und einen zweiten Abschnitt (42) angrenzend an den ersten Abschnitt (41) umfasst.

## Claims

1. A radiofrequency micro-electromechanical switch (1), comprising:
- a semiconductor and/or insulating substrate (2) having an essentially planar face (21);
- a first RF line (3) capable of conveying a RF signal, said first RF line (3) comprising at least one metal layer, said first RF line (3) being arranged on said face (21) of the substrate (2);
- a second RF line (4) capable of conveying a RF signal, said second RF line (4) comprising at least one metal layer;
- a MEMS membrane (5) capable of being deflected by one or more activations of the electrostatic type toward the substrate (2) or in the opposite direction, said MEMS membrane (5) comprising at least one metal layer and being substantially parallel to the substrate (2) and being connected to the first RF line (3) via one or more anchors (51) ;
- a dome (6), having an inner face (61) facing said essentially planar face (21) of the substrate (2) and an outer face (62) opposite said inner face (60), said dome (6) comprising at least one dielectric layer, said dome (6) being arranged between the second RF line (4) and the MEMS membrane (5), and having one or more anchors on said essentially planar face (21) of the substrate (2) and at least one side opening,
said switch being **characterized in that** said second RF line (4) comprises at least a first section (41) in contact with said essentially planar face (21) of the substrate (2), and a second section (42) adjacent and electrically connected to said first section (41), said second section (42) at least partially covering the upper part of said dome (6), and at least one of said second RF line (4) and said first RF line (3) closing said side opening so as to create a sealed cavity (C) encapsulating said MEMS membrane.

2. The switch (1) according to claim 1, wherein the MEMS membrane (5) further comprises at least one dielectric layer and/or one or more additional metal layers.

3. The switch (1) according to claims 1 or 2, wherein said second section (42) of the second RF line (4) is at least partially inserted into said dielectric layer of the dome (6).

4. The switch (1) according to any one of claims 1 to 3, further comprising:
- one or more upper activation electrodes (71) electrically connected to one another and capable of deflecting said MEMS membrane (5) through an electrostatic activation, said upper activation electrode (71) being arranged on the outer face (61) of the dome (6), and/or
- one or more middle activation electrodes (72) electrically connected to one another and capable of deflecting said MEMS membrane (5) through an electrostatic activation, said middle activation electrode (72) being arranged on the inner face (62) of the dome (6), and/or
- one or more lower activation electrodes (72) electrically connected to one another and capable of deflecting said MEMS membrane (5) through an electrostatic activation, said lower activation electrode (73) being arranged on said face (21) of the substrate (2) in the sealed cavity (C).

5. The switch (1) according to claim 4, comprising one or more upper activation electrodes (71), each of them being electrically connected to a middle electrode by means of a metal via (75).

6. The switch (1) according to claims 4 or 5, comprising one or more stop pins (9) arranged in the cavity (C) so as to prevent any contact between the middle or lower activation electrodes (72, 73) and the MEMS membrane (5) when it is deflected.

7. The switch (1) according to any one of claims 4 to 6, wherein said dome (6) includes at least one opening in which is housed a metal pin (91) that is formed in the extension of said second section (42) of the second RF line (4), such that said MEMS membrane (5) and said second section (42) of the second RF line (4) are capable of coming into contact when said MEMS membrane (5) is activated by an upper (71) or middle (72) activation electrode so as to form an ohmic contact.

8. The switch (1) according to any one of claims 1 to 6, wherein the dome comprises at least one dielectric layer separating the MEMS membrane (5) and the second section (42) of the second RF line (4), so as to form a Metal-Dielectric-Metal capacitance when the membrane is activated and in contact with the dome.

9. The switch (1) according to claim 8, wherein a metal layer (63) is arranged below said dielectric layer (62) and comes into contact with the MEMS membrane (5) when said membrane is deflected toward the dome.

10. A radiofrequency micro-electromechanical system (RF MEMS) comprising a switch (1) as defined according to any one of claims 1 to 9.

11. A method for manufacturing a switch (1) as defined according to any one of claims 1 to 9, comprising the following steps:
a) depositing, on an essentially planar face (21) of a semiconductor or insulating substrate (2), a first sacrificial layer (S1) and producing a pattern by lift-off and/or etching of a portion of said layer (S1);
b) depositing, on said first sacrificial layer (S1) and on said face of the substrate (21), at least a first metal layer; then producing a pattern by lift-off and/or etching of a portion of said metal layer, to form the first RF line (3) and the MEMS membrane (5) by connecting the latter (5) to said first RF line (3) through one or more anchors (51);
c) depositing, on said first RF line (3), a second sacrificial layer (S2); then producing a pattern by lift-off and/or etching of a portion of said layer (S2);
d) depositing, on said second sacrificial layer (S2), a dielectric layer; then producing a pattern by lift-off and/or etching of a portion of the dielectric layer, to form the dome (6) having an inner face (61) facing said face (21) of the substrate (2), an outer face (62) opposite said inner face (61), as well as side openings (64, 65) in said dome (6);
e) eliminating the sacrificial layers (S1, S2) through said side openings (64, 65); then
f) depositing, on said outer face (62) of said dome (6) and on said essentially planar face (21) of the substrate (2), at least one second metal layer; then producing a pattern making it possible to plug said side openings (64, 65) and forming the second RF line (4) by lift-off and/or etching of a portion of said second metal layer, said second RF line (4) comprising a first section (41) in contact with said essentially planar face (21) of the substrate (2) and a second section (42) adjacent to said first section (41).
